# EUROPÄISCHE PATENTANMELDUNG

(11) **EP 3 425 733 A1**
(43) Veröffentlichungstag der Anmeldung: **09.01.2019**
(21) Anmeldenummer: 18167881.4
(22) Anmeldetag: 18.04.2018
(51) Int. Cl.: H01Q 3/26, G01S 13/78, G01S 7/40, H04B 17/16

(54) **VERFAHREN ZUR UNTERSUCHUNG VON ANTENNEN MIT MINDESTENS EINER MESSSONDE**

(30) Priorität: 04.07.2017 DE 102017114822
(71) Anmelder: DFS Deutsche Flugsicherung GmbH, 63225 Langen (DE)
(72) Erfinder: Zobel, Rolf, 63165 Mühlheim (DE)
(74) Vertreter: Keil & Schaafhausen Patent- und Rechtsanwälte PartGmbB

(57) **Zusammenfassung**

Die Erfindung betrifft ein Verfahren zur Untersuchung einer Antenne, die mindestens ein Antennenelement aufweist, mit Signalerfassung mittels mindestens einer Messsonde. Das Verfahren umfasst ein Positionieren mindestens einer Messsonde in einer eindeutig festgelegten, mechanischen Position bezüglich mindestens eines Antennenelements, und ein Auskoppeln von elektromagnetischer Strahlung aus einem Antennenelement der Antenne und Übertragung auf mindestens eine Messsonde. Ferner umfasst das Verfahren eine Messung der übertragenen elektromagnetischen Strahlung von mindestens einem Antennenelement auf die mindestens eine Messsonde, wobei die Messsonde(n) auf die Frequenz der aus dem Antennenelement ausgekoppelten elektromagnetischen Strahlung abgestimmt ist. Ein Abstand der Messsonde(n) zu dem/den Antennenelement(en) ist kleiner als eine Wellenlänge der Frequenz der aus dem Antennenelement ausgekoppelten elektromagnetischen Strahlung, und Abstand und Position sind so gewählt, dass eine dem normalen Betriebsfall ähnliche Leistungsverteilung des/ der Antennenelement(e) erfolgt.

## Beschreibung

Die Erfindung betrifft ein Verfahren zur Untersuchung einer Antenne, die mindestens ein Antennenelement aufweist, mit mindestens einer Messsonde.

In der zivilen Luftfahrt werden Radaranlagen zur Überwachung des Luftraums und der Flugsicherung eingesetzt. Insbesondere werden auch MSSR-Radaranlagen eingesetzt. MSSR ist eine Abkürzung für den englischen Begriff "Monopulse Secondary Surveillance Radar" (Monopuls-Sekundärradar). Bei einem solchen Sekundärradar wird von einem Abfragegerät (Interrogator) ein Anfragesignal ausgesendet, welches von einem Luftfahrzeug mit einem Antwort-Signal erwidert wird. Mit dem Sekundärradar kann nicht nur eine Position des Luftfahrzeugs bestimmt werden, sondern mittels des Antwort-Signals können auch zusätzliche Informationen des Luftfahrzeugs übermittelt werden.

Monopulsantennen sind in der Regel arrayförmig aufgebaut und bestehen aus mehreren über- und/oder nebeneinander angeordneten Einzelantennen (Antennenelementen). Sie können mehrere Antennenzeilen in horizontaler Richtung und/oder Antennenspalten (Antennencolumns) in vertikaler Richtung aufweisen. Eine einzelne Antennencolumn kann mehrere Einzelantennen aufweisen. Die Einzelantennen werden nicht immer summenbildend zusammengeschaltet, sondern es werden auch Differenzkanäle gebildet. Durch Vergleiche des Summenkanals und der Differenzkanäle kann eine Position eines Luftfahrzeugs in einem Antennendiagramm genauer bestimmt werden. Eine Antennencolumn besteht in der Regel aus einer Anzahl übereinander angeordneter Antennenelemente. Dies sind einzelne elektrische Elemente ("Strahler"), die innerhalb des Antennencolumns (zum Teil mit unterschiedlicher Gewichtung) zu einer Gesamtfunktionsgruppe, dem Antennencolumn, zusammengeschaltet sind. Die Anzahl kann unterschiedlich sein. Beim MSSR System sind es z.B. elf Antennenelemente, von denen die vier dominanten Antennenelemente 75% der Leistung übertragen. Erfindungsgemäß können bei der vorgeschlagenen Untersuchung der Antenne nur diese gemessen werden.

Im Betrieb von operativen Radaranlagen kommt es jedoch immer wieder zu Ausfällen. Solche Ausfälle können auf Fehler, Störungen und/oder Schäden von Radarantennen zurückgehen. Bisher gibt es jedoch keine einfache und praktische Möglichkeit zur Überprüfung von Radarantennen und damit zur eindeutigen Lokalisierung einer Fehlerquelle. Die Fehlersuche vor Ort ist deshalb mit Unsicherheiten behaftet.

Bei den üblichen, aufwändigen Messmethoden für Antennen werden die Messungen im Fernfeld, also in größeren Abständen von der zu untersuchenden Antenne, durchgeführt. Genauer erfolgen übliche Messungen in Abständen von mehr als dem zehnfachen der Wellenlänge von der Antenne entfernt. Frequenzabhängig sind dazu bei Radarantennen gegebenenfalls Abstände von mehreren Metern notwendig. Zusätzlich ist darauf zu achten, dass die Umgebung frei von für die Messung relevanten Störeinflüssen ist.

In der Praxis können solche Messbedingungen nicht immer ohne weiteres gewährleistet werden. Daher müssen zu untersuchende Antennen häufig demontiert werden. Die Antennen werden dann zur Überprüfung bzw. zur Fehlersuche an einen für die durchzuführenden Messungen geeigneten Ort gebracht und dort untersucht.

Mit den üblichen Messverfahren ist eine Überprüfung und Fehlersuche von Radarantennen vor Ort folglich oft nicht möglich. Der Aufwand für die Messungen bei einer Demontage ist entsprechend hoch. Dadurch entstehen lange Ausfallzeiten und hohe Kosten bei der Überprüfung bzw. Fehlersuche. Insbesondere wenn mehrere Antennen ausfallen, kann es zudem zu Engpässen im Ersatzbestand kommen.

Die Aufgabe der vorliegenden Erfindung besteht darin, ein Verfahren anzugeben, durch das Messungen zur Überprüfung von Antennen und/oder zur Lokalisierung eventueller Fehler von Antennen erleichtert wird.

Die Aufgabe wird gelöst durch ein Verfahren zur Untersuchung einer Antenne mit Merkmalen des Anspruchs 1.

Das Verfahren zur Untersuchung einer Antenne, die mindestens ein Antennenelement aufweist, mit mindestens einer Messsonde umfasst:
- Positionieren mindestens einer Messsonde in einer eindeutig festgelegten Position bezüglich mindestens eines Antennenelements, d.h. relativ zu einer durch ein Antennenelement definierten Position im Raum,
- Auskoppeln von elektromagnetischer Strahlung aus mindestens einem Antennenelement der Antenne und Übertragung auf mindestens eine Messsonde, und
- Messen der von mindestens einem Antennenelement auf mindestens eine Messsonde übertragenen elektromagnetischen Strahlung, wobei die Messsonde auf die Frequenz der aus dem Antennenelement ausgekoppelten elektromagnetischen Strahlung abgestimmt ist,
wobei der Abstand der Messsonde(n) zu dem/den Antennenelement(n) kleiner ist als die Wellenlänge der Frequenz der aus dem Antennenelement ausgekoppelten elektromagnetischen Strahlung und wobei der Abstand und die Position so gewählt sind, dass eine zu einer Messung der aus der Antenne ausgekoppelten elektromagnetischen Strahlung im Fernfeld ähnliche Übertragung von elektromagnetischer Strahlung, bspw. als Energie oder Leistung, an die Messsonde(n) erfolgt. Mit anderen Worten erfolgt eine dem normalen Betriebsfall ähnliche Leistungsverteilung des/der Antennenelement(e). Erfindungsgemäß erfolgt die Messung in nächster Umgebung im Nahbereich außerhalb des Fernfelds.

Als Maß für Position und Abstand gilt hier eine vertretbare Impedanzanpassung zu erreichen, in der die Rückwirkung auf das Gesamtsystem gering bleibt (systemabhängig). Zusätzlich muss sichergestellt sein, dass die mechanische Positionierung zu reproduzierbaren Ergebnissen führt und äußere (systemabhängige) Einflüsse möglichst gering bleiben.

Die Anzahl der Antennenelemente muss nicht der Anzahl der Messsonden entsprechen (z.B. kann ein Antennenmodul oder -column bestehend aus elf Antennenelementen mit einer Messsondeneinheit aus vier miteinander verkoppelten Messsonden für die vier dominantesten Elemente für 75% der abgestrahlten Leistung gemessen werden).

Besteht ein Antennensystem aus einer Gruppe mehrerer Antennenelemente oder gar aus mehreren Antennenelementgruppen (Arrays), so kann man die Anteile der Verteilung der elektromagnetischen Strahlung und damit die Strahlungsdiagramme des Antennensystems ermitteln.

Das erfindungsgemäße Verfahren stellt zwar eine klare Verletzung der idealen Abstrahlverhältnisse und Anpassbedingungen der Antenne beziehungsweise mindestens eines Antennenelements dar, erlaubt aber eine relativ schnelle und einfache Beurteilung der Antenne unter schwierigen Messbedingungen und kleinen Abständen.

Mit der vorliegenden Erfindung kann die Prüfung, Wartung und/oder Reparatur von Antennen einfacher, zielorientierter, schneller und kostengünstiger ausgeführt werden. Entsprechend kann eine Ausfallzeit von Antennen verkürzt werden. Gegebenenfalls kann die Antenne sogar vor Ort, also im eingebauten Zustand, gemessen, überprüft und repariert werden. Die Antenne bzw. die Antennenanlage ist schnellstmöglich wieder für den Betrieb verfügbar, und es ergeben sich keine unnötigen Antennenwechsel, Flugvermessungen oder Unsicherheiten bei der Fehlersuche.

Außerdem sind mit dem erfindungsgemäßen Verfahren zum Teil sogar Beurteilungen von Antennen und Antennendiagrammen in Umgebungen möglich, die für Hochfrequenzmessungen als schwierige Umgebungen gelten, bspw. in Metallcontainern oder vor Metallzäunen. Das erfindungsgemäße Verfahren gewährleistet außerdem eine gute Reproduzierbarkeit der Messwerte.

Bevorzugt ist der Abstand der Messsonde(n) zu dem/den Antennenelement(n) so gewählt, dass ein vertretbarer Kompromiss zwischen Impedanzanpassung, geringem Abstand (der Messsonde zu dem Antennenelement) und reproduzierbarer mechanischer Positionierung der beiden Einheiten zueinander erreicht wird.

Das erfindungsgemäße Verfahren wird bevorzugt zur Messung, Fehlersuche und/oder Abschätzung der Funktionalität von Radarantennen verwendet. Im Allgemeinen kann jedoch auch für Antennentypen anderer Systeme, bspw. im Navigationsbereich für sogenannte Localizer von Instrumentenlandesystemen, verwendet werden.

Die Messsonde(n) und Antennenelement(e) müssen nicht direkt gegenüberliegend positioniert sein. Es kann aus Gründen der Anpassung oder aus feldrelevanten Gründen günstiger sein, wenn die Messsonde(n) versetzt zu dem/den Antennenelement(en) positioniert wird/werden. Dies gilt entsprechend, wenn eine Messeinheit mit mehr als einer Messsonde verwendet wird.

In einer bevorzugten Ausführungsform des erfindungsgemäßen Verfahrens wird die Funktionalität der Antennenelement(e) anhand eines Vergleichs mit Referenzmesswerten einer vergleichbaren, funktionsfähigen Anordnung beurteilt. Dadurch kann sehr einfach und schnell eine Aussage über die Funktionalität des/der Antennenelements(e) getroffen werden.

In einer besonders bevorzugten Ausführungsform des erfindungsgemäßen Verfahrens sind die Referenzmesswerte zuvor an einem Antennenelement in funktionsfähigem Zustand mit derselben Messsonde oder einer gleichartigen Messsonde an derselben Position bezüglich des/der Antennenelements(e) gemessen worden.

Es kann sich bei der Antenne um eine Radarantenne, beispielswiese um eine MSSR-Antenne, handeln. Bei solchen Antennen ist das erfindungsgemäße Verfahren vorteilhaft, da diese aufgrund ihrer Größe und ihrer Standorte mit konventionellen Verfahren besonders schlecht und/oder aufwendig zu prüfen sind. Es kann sich um eine Radarantenne bzw. eine MSSR-Antenne für Flugsicherungssystem für die zivile Luftfahrt handeln.

In einer Weiterbildung des erfindungsgemäßen Verfahrens erfolgt die Positionierung der Messsonde(n) durch eine eindeutige, direkte mechanische Fixierung an der Antenne. Besonders bevorzugt erfolgt die Fixierung an der Antenne, insbesondere durch eine Klemmfixierung. Somit ist eine reproduzierbare Positionierung der Messsonde(n) zu der Antenne und den Antennenelement(en) sichergestellt. Das erhöht die Reproduzierbarkeit der Messergebnisse.

In einer bevorzugten Ausführungsform der Erfindung wird eine Antenne, die mindestens zwei Antennenelemente aufweist, mit mindestens zwei Messsonden untersucht, wobei jede Messsonde jeweils einem Antennenelement eindeutig zugeordnet ist, in einer eindeutig festgelegten, bspw. mechanischen definierten, Position bezüglich dieses Antennenelements positioniert wird und auf die Frequenz der aus diesem Antennenelement ausgekoppelten elektromagnetischen Strahlung abgestimmt ist.

Bei Anordnungen mit mehreren Antennenelementen können zudem Antennendiagramme qualitativ bewertet werden. Wenn die antenneninterne Leistungsverteilung auf die einzelnen Antennenelemente bekannt ist, kann der Bereich, in dem ein Fehler vorliegt, sicher eingegrenzt werden. Es müssen dann nur solche Verbindungen und Abdichtungen der Antenne geöffnet werden, welche im Bereich des Fehlers liegen. Verbindungen und Abdichtungen anderer Bereiche der Antenne brauchen dagegen nicht geöffnet zu werden. Zudem wird das Risiko von Fehlern beim Zusammenbau der Antennen, wie bspw. Undichtigkeiten oder Kontaktprobleme, erheblich reduziert, da nur noch betroffene Verbindungen und Abdichtungen überhaupt geöffnet werden müssen. Mit dem erfindungsgemäßen Verfahren wird also das Störungs- und Ausfallrisiko der Antenne nach einer Wartung bzw. Reparatur deutlich verringert.

Besonders bevorzugt wird eine Messeinheit verwendet, die die mindestens zwei Messsonden aufweist. Die Messeinheit kann einfach an der zu prüfenden Antenne angebracht werden, bspw. durch eine Klemmfixierung. Dadurch werden die mindestens zwei Messsonden jeweils eindeutig und reproduzierbar zu den mindestens zwei Antennenelementen positioniert. Überaus bevorzugt ist die Messeinheit derart ausgestaltet, dass lediglich solche der mindestens zwei Antennenelemente gemessen werden, die leistungsmäßig maßgeblich an einem Diagramm der Antenne beteiligt sind. Als leistungsmäßig relevant werden dabei bevorzugt die Antennenelemente betrachtet, die zusammen mindestens 75 Prozent zur Gesamtleistung der Antenne beitragen, wie bereits erläutert.

Bevorzugt ist eine gewünschte Leistungsverteilung innerhalb der Antenne bekannt und/oder gemessen worden. Dann kann eine Fehlfunktion der Antenne durch direkten Vergleich von Messwerten bezüglich der Leistungsverteilung mit der gewünschten Leistungsverteilung erkannt werden.

In einer Weiterbildung der Erfindung wird mit einer Messeinheit, die an die Antenne angebracht wird, und mittels eines mobilen Netzwerkanalysators jeweils an allen einzelnen Antennencolumns der Antenne ein einzelner Leistungsanteil einer horizontalen Gesamtantennendiagrammverteilung gemessen. Dadurch erhält man eine Information über die horizontale Gesamtantennendiagrammverteilung und kann insbesondere feststellen, ob die Leistungsanteile verschiedener Antennencolumns voneinander abweichen.

Besonders bevorzugt erfolgen bei einer Abweichung der Leistungsanteile der einzelnen Antennencolumns Einzelmessungen der jeweils entsprechenden einzelnen Antennencolumns. So kann die Funktionalität der einzelnen Antennencolumns gezielt geprüft werden.

In einer besonders bevorzugten Ausführungsform des erfindungsgemäßen Verfahrens werden zunächst die (S11-)Werte für die Impedanzanpassung der MSSR-Antennenkanäle Σ, Δ, Ω und danach die gesamte Leistungsverteilung der Eingänge auf die einzelnen Antennencolumns erfasst. Die MSSR- Radarantenne hat drei Eingänge (bzw. Diagramme): Σ, Δ, Ω

Mit dem erfindungsgemäßen Verfahren wird der Wartungs- bzw. Reparaturaufwand erheblich verringert. Mit dem vorgeschlagenen Verfahren können Antennen anhand von Messwerten beurteilt werden, die in nächster Umgebung, also ohne die sonst übliche, aufwändige Messung im Fernfeld, gemessen werden. Deshalb ist in der Regel auch ohne Demontage der Radarantenne eine gute Beurteilung ihrer Funktionalität möglich.

## Patentansprüche

1. Verfahren zur Untersuchung von Antennen, die mindestens ein Antennenelement aufweisen, mit Signalerfassung mittels mindestens einer Messsonde, umfassend:
- Positionieren der mindestens einen Messsonde in einer eindeutig festgelegten Position bezüglich des mindestens einen Antennenelements,
- Auskoppeln von elektromagnetischer Strahlung aus dem mindestens einen Antennenelement der Antenne und Übertragung auf die mindestens eine Messsonde, und
- Messen der von dem mindestens einen Antennenelement auf die mindestens eine Messsonde übertragenen elektromagnetischen Strahlung, wobei die mindestens eine Messsonde auf die Frequenz der aus dem Antennenelement ausgekoppelten elektromagnetischen Strahlung abgestimmt ist,
wobei der Abstand der mindestens einen Messsonde zu dem mindestens einen Antennenelement kleiner ist als die Wellenlänge der Frequenz der aus dem Antennenelement ausgekoppelten elektromagnetischen Strahlung und wobei der Abstand so gewählt ist, dass eine zu einer Messung der aus der Antenne ausgekoppelten elektromagnetischen Strahlung im Fernfeld ähnliche Übertragung von elektromagnetischer Strahlung an die mindestens eine Messsonde erfolgt.

2. Verfahren nach Anspruch 1, **dadurch gekennzeichnet, dass** die Funktionalität des mindestens einen zu prüfenden Antennenelements anhand eines Vergleichs mit Referenzmesswerten einer vergleichbaren, funktionsfähigen Anordnung beurteilt wird.

3. Verfahren nach Anspruch 2, **dadurch gekennzeichnet, dass** die Referenzmesswerte zuvor an dem mindestens einen Antennenelement in funktionsfähigem Zustand mit derselben Messsonde oder einer gleichartigen Messsonde in derselben Position bezüglich des mindestens einen Antennenelements gemessen worden sind.

4. Verfahren nach einem der vorhergehenden Ansprüche, **dadurch gekennzeichnet, dass** es sich bei der Antenne um eine Radarantenne, insbesondere eine MSSR-Antenne, handelt.

5. Verfahren nach einem der vorhergehenden Ansprüche, **dadurch gekennzeichnet, dass** die Positionierung der mindestens einen Messsonde durch eine mechanische Fixierung an der Antenne erfolgt.

6. Verfahren nach einem der vorhergehenden Ansprüche, **dadurch gekennzeichnet, dass** eine Antenne, die mindestens zwei Antennenelemente aufweist, mit mindestens zwei Messsonden untersucht wird, wobei jede Messsonde jeweils einem Antennenelement eindeutig zugeordnet ist, in einer eindeutig festgelegten Position bezüglich dieses Antennenelements positioniert wird und auf eine Frequenz der aus diesem Antennenelement ausgekoppelten elektromagnetischen Strahlung abgestimmt ist.

7. Verfahren nach Anspruch 6, **dadurch gekennzeichnet, dass** eine gewünschte Leistungsverteilung innerhalb der Antenne bekannt ist und/oder gemessen worden ist.

8. Verfahren nach Anspruch 6 oder 7, **dadurch gekennzeichnet, dass** mit einer Messeinheit, die an die Antenne angebracht wird, und mittels eines mobilen Netzwerkanalysators jeweils an allen einzelnen Antennencolumns ein einzelner Leistungsanteil einer horizontalen Gesamtantennendiagrammverteilung gemessen wird.

9. Verfahren nach Anspruche 8, **dadurch gekennzeichnet, dass** bei einer Abweichung der Leistungsanteile der einzelnen Antennencolumns Einzelmessungen der jeweils entsprechenden einzelnen Antennencolumns erfolgen.
